Europäisches Patentamt

**European Patent Office**

**Office européen des brevets**

(19)

(11) Veröffentlichungsnummer : **0 233 861**
**B1**

(12) **EUROPÄISCHE PATENTSCHRIFT**

(45) Veröffentlichungstag der Patentschrift :
02.11.89

(51) Int. Cl.⁴ : $G\ 11\ C\ 17/00$

(21) Anmeldenummer : **85904236.8**

(22) Anmeldetag : **31.08.85**

(86) Internationale Anmeldenummer :
**PCT/DE 85/00301**

(87) Internationale Veröffentlichungsnummer :
**WO/8603328 (05.06.86 Gazette 86/12)**

(54) **VERFAHREN ZUR PROGRAMMIERUNG EINES NICHTFLÜCHTIGEN SPEICHERS.**

(30) Priorität : 01.12.84 DE 3443997

(73) Patentinhaber : **ROBERT BOSCH GMBH**
**Postfach 50**
**D-7000 Stuttgart 1 (DE)**

(72) Erfinder : **HOEBEL, Andreas**
**Adalbertstrasse 5**
**D-8500 Nürnberg 70 (DE)**
Erfinder : **MEYER, Dieter**
**Industriestrasse 15**
**D-8501 Feucht (DE)**

(43) Veröffentlichungstag der Anmeldung :
02.09.87 Patentblatt 87/36

(45) Bekanntmachung des Hinweises auf die Patenterteilung : 02.11.89 Patentblatt 89/44

(84) Benannte Vertragsstaaten :
DE FR GB IT SE

(56) Entgegenhaltungen :
WO--A--80 /028 81
E.D.N. Electrical Design News, Band 28, Nr. 21, 13. Oktober 1983, Boston, (US) A. J. Morales et al.: "Adding EEPROM to ROM expands 1c versatility", Seiten 177-188

## Beschreibung

### Stand der Technik

Die Erfindung geht aus von einem Verfahren zum Programmieren eines nichtflüchtigen Speichers zur Datenverarbeitung nach der Gattung des Hauptanspruchs. Ein solches Verfahren ist aus WO-A-80/02881 bekannt.

Bei der Anzeige von Fahrdaten im Kraftfahrzeug, beispielsweise der Motordrehzahl, der Fahrgeschwindigkeit oder des Kraftstoffverbrauchs ist es z.B. aus der DE-A-33 05 579 bekannt, die von den entsprechenden Sensoren für die Motordrehzahl, Raddrehzahl oder Kraftstoffdurchflußmenge abgegebenen Impulse über Tabellen umzurechnen, die fahrzeugspezifisch in einem ROM oder PROM eines Mikrocomputers gespeichert sind. Dieser nichtflüchtige Speicher wird dabei entweder beim Hersteller selbst oder vor dem Einbau in die Datenverarbeitungseinrichtung programmiert. Die Tabellenwerte sind dabei für jeden Fahrzeugtyp fest vorgegeben und können nach dem Einbau des nichtflüchtigen Speichers beispielsweise durch Verwendung anderer Sensoren nicht mehr geändert werden. Zwar können über spezielle Programmiereingänge einzelne Kenndaten und Tabellen aus dem PROM ausgewählt werden, sofern in einem ausreichend großen Speicher eine entsprechende Auswahl zur Verfügung steht. Durch die Vielzahl der voneinander abweichenden Fahrzeugtypen wird aber dennoch eine Vielzahl unterschiedlich programmierter Speicher benötigt, was relativ kostenaufwendig ist. Ein Umrüsten oder Auswechseln defekter Sensoren ist nur möglich, wenn die neuen Sensoren auf die im Speicher abgelegten Tabellenwerte abgestimmt sind.

Es ist ferner bekannt (Elektronik Nr. 22, 1982, S. 143 ff), zur Änderung von in einem nichtflüchtigen Speicher abgelegten Daten einen umprogrammierbaren nichtflüchtigen Speicher zu verwenden, der mit einem Mikrocomputer oder Mikroprozessor fest verbunden ist und über eine Schnittstelle jederzeit umprogrammiert werden kann. Dabei ist nachteilig, daß hier für den sogenannten EEPROM zusätzliche Anschlußstellen geschaffen werden müssen, die in einem Kraftfahrzeug das Eindringen von Schmutz und/ oder Feuchtigkeit in die Elektronik erleichtern.

Mit der vorliegenden Lösung wird angestrebt, mit den für den Betrieb der Datenverarbeitungs-Einrichtung ohnehin benötigten Eingängen bzw. Eingangsleitungen eine Programmierung oder Umprogrammierung des nichtflüchtigen Speichers vornehmen zu können.

### Vorteile der Erfindung

Die erfindungsgemäßen Verfahrensschritte nach den kennzeichnenden Merkmalen des Hauptanspruchs haben den Vorteil, daß mit den vorhandenen Anschlußleitungen des Mikroprozessors oder Mikrocomputers ein damit fest verbundener nichtflüchtiger Speicher über ein Unterprogramm des Mikroprozessors programmierbar ist. So können gespeicherte Daten oder Programme im Bedarfsfalle jederzeit geändert werden. Es kann ein und derselbe nichtflüchtige Speicher für die verschiedenen Fahrzeugtypen eingesetzt werden, was eine erhebliche Vereinfachung für die Lagerhaltung bedeutet. Selbst bei der Einführung neuer Fahrzeugmodelle ist eine Änderung der Hardware in der Datenverarbeitungs-Einrichtung nicht mehr erforderlich, da die fahrzeugspezifischen Programme, Kennzahlen, Kennlinien und Tabellen vom Fahrzeughersteller als Software ermittelt werden können, die dann mit einer Programmiereinrichtung über den Mikrocomputer bzw. Mikroprozessor in den nichtflüchtigen Speicher einzugeben sind. Als weiterer Vorteil ist anzusehen, daß bei dieser Lösung selbst in Werkstätten beim Austausch defekter Sensoren oder anderer elektronischer Bauelemente eine Umprogrammierung der diesen Teilen zugeordneten Daten im nichtflüchtigen Speicher über die vorhandenen Eingangsleitungen ohne weiteres möglich ist.

Durch die in den Unteransprüchen aufgeführten Maßnahmen sind vorteilhafte Weiterbildungen und Verbesserungen der im Hauptanspruch angegebenen Merkmale möglich. Besonders vorteilhaft ist, wenn die zu speichernden Daten in mehreren Datenfolgen zyklisch nacheinander jeweils in einen Zwischenspeicher des Mikroprozessors eingelesen und von dort in den nichtflüchtigen Speicher eingeschrieben werden. Dabei wird zweckmäßigerweise das Einlesen der Daten einer Datenfolge in den Zwischenspeicher durch weitere Steuerbefehle auf einer dafür vorgesehenen Eingangsleitung vorgenommen. Ferner ist es vorteilhaft, wenn bereits vor der ersten Datenfolge eine Anfangsadresse für den nichtflüchtigen Speicher über dieselbe Eingangsleitung bzw. -leitungen in den Mikroprozessor eingegeben wird, über welche auch die anschließend eingegebenen Daten in den Mikroprozessor gelangen.

Die Programmierung des nichtflüchtigen Speichers kann dabei über Schalter einer externen Programmiereinrichtung erfolgen, mit denen die Adressen und Daten erzeugt werden. Steuerbefehl, Anfangsadresse sowie Datenfolge kann aber ebenso durch einen externen Rechner erzeugt werden, der an die entsprechende Eingangs- bzw. Datenleitung des Mikroprozessors angeschlossen ist.

### Zeichnung

Ein Ausführungsbeispiel der Erfindung ist in der Zeichnung dargestellt und in der nachfolgenden Beschreibung näher erläutert. Es zeigt Figur 1 ein Blockschaltbild einer Datenverarbeitungseinrichtung mit einem EEPROM und einer externen Programmiereinrichtung, Figur 2 zeigt ein Impulsdiagramm für die Dateneingabe von Hand über fünf Eingänge des Mikroprozessors, Figur 3 zeigt ein Flußdiagramm zur Programmierung des EEPROM von Hand, Figur 4 zeigt ein Impulsdiagramm für einr automatische Programmierung des EPROMs durch einen Programmierrechner und Figur 5 zeigt das entsprechende Flußdiagramm zur Programmeingabe.

Beschreibung des Ausführungsbeispieles

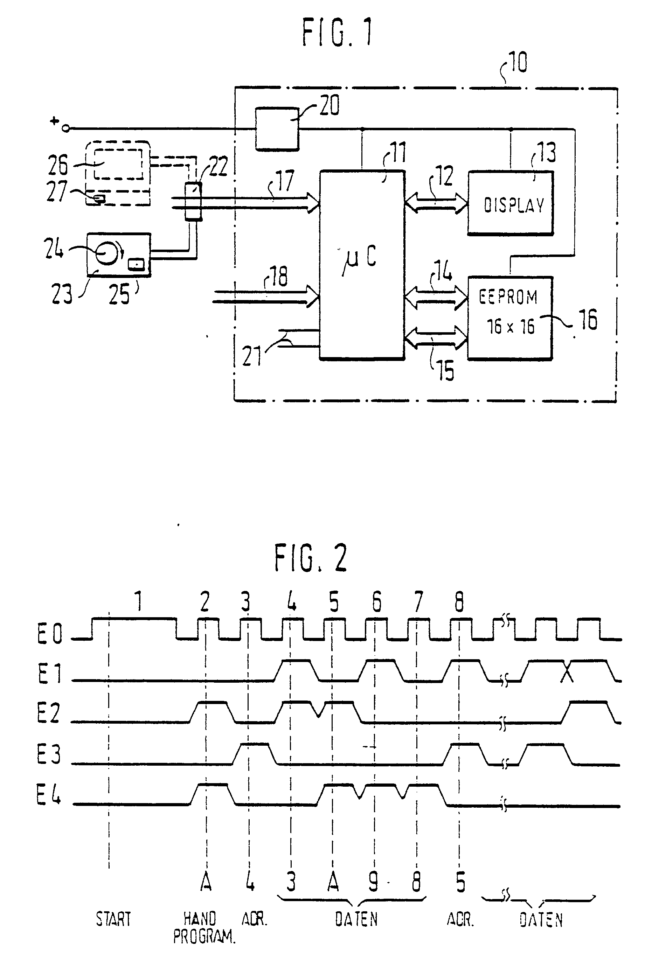

In Figur 1 ist das Blockschaltbild eines Fahrdatenrechners 10 in einem Kraftfahrzeug dargestellt. Er enthält zur Datenverarbeitung einen Mikrocomputer 11, der über einen Port 12 mit einem Display 13 verbunden ist, auf dem die ermittelten Daten angezeigt werden sollen. Der Mikrocomputer 11 ist ferner über einen Adressbus 14 und einen Datenbus 15 mit einem EEPROM 16 als nichtflüchtigen Speicher verbunden. Verschiedene, nicht dargestellte Sensoren sind mit Eingangsleitungen über einen Eingangsport 17 am Mikrocomputer 11 angeschlossen. Über einen weiteren Eingangsport 18 können weitere Sensoren bzw. Funktionsschalter oder Tastschalter angeschlossen werden. Weitere Eingangsleitungen 21 des Mikrocomputers 11 können zur Eingabe von Steuerbefehlen, Daten oder Adressen verwendet werden. Über einen Spannungsregler 20 werden Mikrocomputer 11, Display 13 und EEPROM 16 zur Spannungsversorgung an das Pluspotential des Fahrzeugbordnetzes angeschlossen. Über eine Steckvorrichtung 22 ist eine Programmiereinrichtung 23 mit den Leitungen des Eingangsports 17 lösbar verbunden. Die Programmiereinrichtung 23 hat einen hexadezimalcodierten Drehschalter 24 mit vier Ausgängen und einen Tastschalter 25. Die Programmiereinrichtung 23 kann ebenso aus einem computergesteuerten Eingabegerät 26 mit einer Eingabetaste 27 bestehen, das in Figur 1 gestrichelt angedeutet ist.

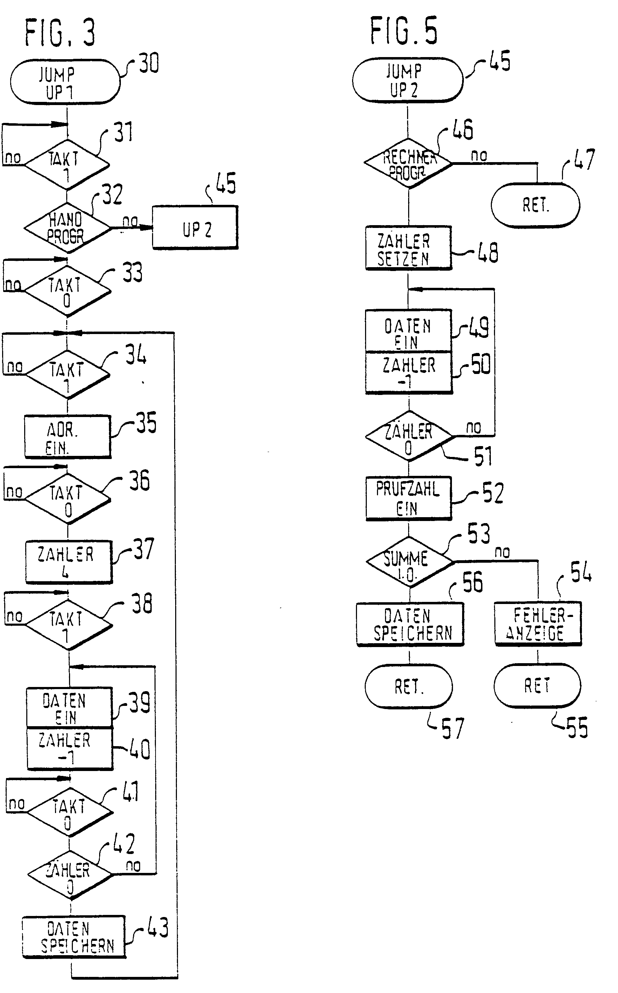

Anhand der Figuren 2 und 3 soll nunmehr erläutert werden, auf welche Weise fahrzeugspezifische Kenndaten und dgl. mit der Programmiereinrichtung 23 über den Mikrocomputer 11 in den EEPROM 16 eingespeichert werden, der 16 × 16 Speicherstellen hat. Als fahrzeugspezifische Daten sollen beispielsweise unter anderem eine Kennzahl für einen Weggeber zur Bestimmung der gefahrenen Wegstrecke, eine Kraftstoffverbrauchskennzahl für einen Kraftstoffdurchflußmesser, eine Tabelle für den Füllstandssensor im Kraftstofftank zur Kraftstoffanzeige und eine Kennzahl für den Drehzahlsensor am Motor in den nichtflüchtigen Speicher eingegeben werden. Ferner kann bei einer vorgegebenen Tankfüllung eine Tankkorrekturzahl sowie bei zuvor ermittelter Quarzfrequenz des Mikrocomputers 11 eine Quarzkorrekturzahl abgespeichert werden. Die im EEPROM 16 zu speichernden Daten werden dann später zur Berechnung und zur Anzeige von Fahrdaten im Mikrocomputer 11 verarbeitet. Die zu speichernden Daten werden zunächst fahrzeugspezifisch ermittelt und als Software in einer hexadezimalcodierten 4-bit-Zahlenfolge erstellt. Vier solcher aufeinanderfolgender Hexadezimalzahlen bilden dabei eine Datenfolge bzw. ein Datenwort, was jeweils in einer Zeile des EEPROM 16 abgespeichert werden soll. Die dafür vorgesehene Adresse des EEPROM 16 wird ebenfalls als hexadezimale 4-bit-Binärzahl angegeben.

Wie Figur 2 zeigt, wird zur Eingabe von Steuerbefehlen ein erster Eingang Eo und zur Eingabe der Daten werden weitere vier Eingänge E1 bis E4 verwendet. Der Eingang E0 ist dabei mit dem Tastschalter 25 und die Eingänge E1 bis E4 sind mit dem Drehschalter 24 der Programmiereinrichtung 23 lösbar verbunden. Durch Betätigen des Tastschalters 25 für eine Zeit von mehr als 1 Sekunde wird über den Eingang E0 ein Steuerbefehl auf dem Mikrocomputer 11 gegeben, der in Figur 2 als erster Taktimpuls dargestellt ist. Mit diesem Steuerbefehl wird im Mikrocomputer 11 ein Unterprogramm UP1 aufgerufen, sofern die Eingänge E1 bis E4 kein Signal führen. Der Drehschalter 24 ist daher zuvor auf Nullstellung zu bringen. Der Aufruf des Unterprogramms UP1 erfolgt somit im Programmschritt 30 nach Figur 3, wenn der am Eingang Eo auftretende erste Taktimpuls länger als 1 Sekunde ansteht. Anschließend ist am Drehschalter 24 die hexadezimale Kennzahl « A » für die Handprogrammierung einzustellen. Im folgenden Programmschritt 31 wird jetzt abgewartet, bis mit erneuter Betätigung des Tastschalters 25 ein zweiter Taktimpuls am Eingang Eo auftritt. Im Schritt 32 wird nun geprüft, ob die Kennzahl für die Handprogrammierung über die Eingänge E1 bis E4 eingegeben wurde. Ist dies der Fall, so wird im folgenden Schritt 33 das Ende des zweiten Taktimpulses abgewartet. Über den Drehschalter 24 wird nun an den Eingängen E1 bis E4 die Anfangsadresse eingestellt, die im Beispielsfall die hexadezimale Binärzahl « 4 » ist. Die an den Eingängen E1 bis E4 anstehende Hexadezimalzahl wird dabei über den Mikrocomputer 11 ständig auf dem Display 13 angezeigt. Im nachfolgenden Programmschritt 34 wird nunmehr die erneute Betätigung des Tastschalters 25 abgewartet und erst mit dem dritten Taktimpuls wird die eingestellte Anfangsadresse im Programmschritt 35 in einem RAM des Mikrocomputers 11 zwischengespeichert. Anschließend wird im Programmschritt 36 das Ende des dritten Taktimpulses am Eingang Eo abgewartet und zur Speicherung einer nachfolgenden Datenfolge für die adressierte Zeile des EEPROM 16 wird im Schritt 37 ein Schleifenzähler auf vier gestellt, um das nachfolgende Datenwort 3A 98 für die adressierte Zeile im EEPROM zunächst in den Mikrocomputer 11 einlesen zu können.

Zum Einlesen und Abspeichern des Datenwortes wird zunächst der Drehschalter 24 auf die Hexadezimalzahl 13 gestellt. Sie erscheint zur Kontrolle zugleich auf der Anzeige 13. Dann wird der Tastschalter 25 betätigt. Der damit ausgelöste vierte Taktimpuls am Eingang Eo wird im Programmschritt 38 erfaßt und im Schritt 39 im RAM des Mikrocomputers 11 zwischengespeichert. Im Schritt 40 wird nun der Schleifenzähler um 1 decrementiert und im Schritt 41 wird das Ende des vierten Taktimpulses abgewartet. Im Programmschritt 42 wird nun der Zählerstand geprüft. Da er noch nicht auf Null steht, wird nunmehr die Programmschleife mit den Schritten 39 bis 42 noch dreimal durchlaufen und dabei werden jeweils mit den Taktimpulsen 5, 6 und 7 die Hexadezimalzahlen A, 9 und 8 im RAM des Mikrocomputers 11 zwischengespeichert. Nach dem siebten Taktimpuls ist nunmehr das ganze Datenwort vom Mikrocomputer 11 erfaßt und es wird im nachfolgenden Programmschritt 43 zwischen dem siebten und achten Taktimpuls aus dem Zwischenspeicher des Mikrocomputers an die adressierte Zeile in den EEPROM 16 eingeschrieben. Anschließend springt das Programm wieder auf den Programmschritt 34 zurück und es muß nun für eine weitere Datenfolge bzw. für ein weiteres Datenwort eine neue Adresse im EEPROM 16 durch den Drehschalter 24 der Programmiereinrichtung 23 angewählt werden. Die neue Adresse wird dann im Taktimpuls 8 wieder vom Mikrocomputer 11 übernommen und die zuvor beschriebenen Programmschritte 36 bis 43 zum Einschreiben weiterer Daten in die adressierte Zeile des EEPROM 16 werden erneut durchlaufen. Am Ende der Programmierung wird die Spannung des Fahrdatenrechners 10 abgeschaltet.

Mit dem Unterprogramm UP1 können Kenndaten zeilenweise in den EEPROM 16 eingeschrieben bzw. im Bedarfsfalle geändert werden. Eine Änderung der gespeicherten Daten ist folglich auch durch eine sehr einfach aufgebaute Programmiereinrichtung 23 in einer Kfz-Werkstatt möglich. Die an den Eingängen E1 bis E4 jeweils anstehenden Daten bzw. die Adresse erscheinen dabei jeweils zur Kontrolle auf dem Display 13. Durch eine entsprechende Programmergänzung kann auch vor oder nach der Programmierung bzw. Umprogrammierung des EEPROM 16 dessen Inhalt an der angewählten Adresse jeweils auf dem Display 13 ausgegeben werden.

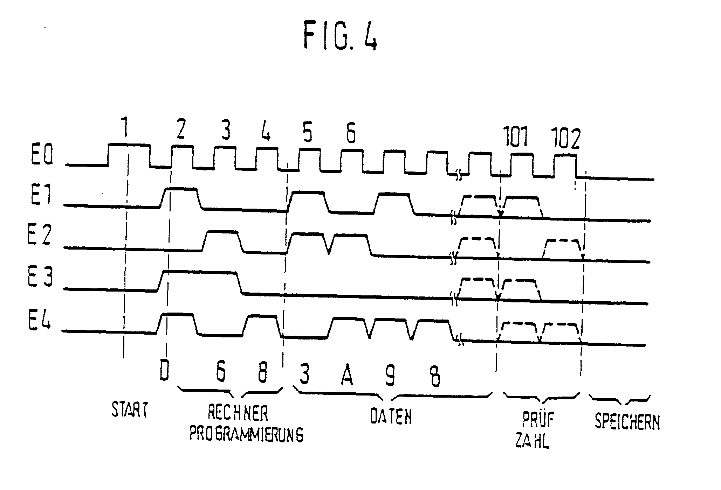

Für die Serienfertigung von Kraftfahrzeugen ist die fahrzeugspezifische Programmierung des EEPROM 16 von Hand relativ zeitaufwendig. Sie läßt sich durch eine rechnergesteuerte Programmierung ersetzen, welche wesentlich schneller arbeitet. Zu diesem Zweck werden beispielsweise im Zentrallager die mit einem einheitlichen EEPROM 16 bestückten Fahrdatenrechner 10 zur Programmierung an ein Eingabegerät 26 angeschlossen, welches die Kenndaten der verschiedenen Fahrzeugtypen als Software enthält. Am Eingabegerät 26 wird dann lediglich der Fahrzeugtyp eingegeben, für den der Fahrdatenrechner 10 jeweils verwendet werden soll. Die Programmierung des EEPROMs 16 erfolgt dann durch Betätigung der Eingabetaste 27 am Eingabegerät 26 vollautomatisch. Die dabei an den Eingängen Eo bis E4 auftretenden Impulse sind in Figur 4 dargestellt und das dafür verwendete Flußdiagramm des entsprechenden Unterprogrammes UP2 ist in Figur 5 dargestellt.

Zur Programmierung des EEPROMs 16 wird zunächst mit der Eingabetaste 27 des Eingabegerätes 26 auf dem Eingang Eo ein erster Taktimpuls als Steuerbefehl auf dem Mikrocomputer 11 gegeben, der für eine Zeit von mehr als 1 Sekunde anstehen muß. Wenn an den Eingängen E1 bis E4 keine Signale anstehen, so wird mit diesem Steuerbefehl das Unterprogramm UP1 gemäß Programmschritt 30 aus Figur 3 aufgerufen. Am Ende dieses Steuerbefehles werden nun vom Eingabegerät 26 automatisch weitere Taktimpulse auf den Eingang Eo gegeben, wobei die Pausenzeit und die Taktzeit jeweils 40 ms beträgt. Im Programm wird jetzt im Schritt 31 der zweite Taktimpuls abgewartet und dann wird im Schritt 32 mit den Signalen an den Eingängen E1 bis E4 geprüft, ob eine Handprogrammierung oder Rechnerprogrammierung durchgeführt werden soll. Da das Eingabegerät 26 beim zweiten Taktimpulse die Hexadezimalzahl D auf die Eingänge E1 bis E4 gibt, springt nunmehr das Programm im Schritt 45 auf das Unterprogramm UP2. Im nachfolgenden Programmabschnitt 46 wird mit drei Taktimpulsen geprüft, ob die für die Rechnerprogrammierung vorgesehene hexadezimale Kennung D68 vom Eingabegerät 26 in entsprechender Zahlenfolge auf die Eingänge E1 bis E4 gegeben wird. Ist dies nicht der Fall, so springt das Programm im Schritt 47 zurück in das Betriebsprogramm des Mikrocomputers 11. Erkennt der Mikrocomputer 11 im Schritt 46 die eingegebene hexadezimale Kennzahl als richtig an, so wird im Schritt 48 der Schleifenzähler auf die Gesamtzahl der nachfolgend einzugebenden Kenndaten gesetzt. Im Programmschritt 49 werden nun mit dem fünften Taktimpuls die ersten Daten über die Eingänge E1 bis E4 in hexadezimaler Kodierung in den Mikrocomputer 11 eingelesen und dort in einem Zwischenspeicher abgelegt. Anschließend wird im Schritt 50 der Schleiferzähler dekrementiert und im Schritt 51 wird die Zählerstellung abgefragt. Solange noch nicht sämtliche Daten der vom Eingabegerät 26 ausgegebenen Datenfolge im Zwischenspeicher des Mikrocomputers 11 eingelesen sind, werden diese über eine Programmschleife mit den Programmschritten 49 bis 51 eingelesen. Anschließend wird im Programmabschnitt 52 beispielsweise mit den Taktimpulsen 101 und 102 in Figur 4 vom Eingabegerät 26 eine Prüfzahl über die Eingänge E1 bis E4 eingegeben, die beispielsweise der Summe der eingegebenen Datenfolge entspricht. Im Programmschritt 53 wird nun im Mikrocomputer 11 geprüft, ob die Prüfzahl mit der Datensumme übereinstimmt. Ist das nicht der Fall, so wird im Programmschritt 54 am Display 13 eine erneute Programmeingabe angefordert und im Schritt 55 springt das Programm wieder in das Betriebsprogramm zurück. Stimmt die Summe der eingegebenen Daten mit der Prüfzahl überein, so werden im Programmabschnitt 56 sämtliche im Zwischenspeicher des Mikrocomputers 11 eingelesenen Kenndaten in dem EEPROM 16 eingeschrieben. Die richtige Adressierung des Speichers 16 für die einzelnen Daten der Datenfolge wird dabei vom Mikrocomputer 11 vorgenommen. Mit dem Schritt 57 gelangt man schließlich wieder ins Betriebsprogramm.

Da die Kennzahl für die Rechnerprogrammierung drei hexadezimale Stellen umfaßt, kann beispielsweise durch Änderung der letzten Prüfziffer im Bedarfsfalle auch ein anderes Unterprogramm für die Programmierung des nichtflüchtigen Speichers 16 aufgerufen werden. Dadurch ist es möglich, im Bedarfsfalle auch die Anfangsadresse für die im Speicher 16 abzuspeichernden Kenndaten anzugeben. Durch Inkrementieren eines Adresszählers im Mikrocomputer 11 werden dann die nachfolgenden Daten entsprechend geordnet in den Speicher 16 eingeschrieben.

Abweichend von dem beschriebenen Ausführungsbeispiel ist es selbstverständlich auch möglich, die Kenndaten nicht über die vier Eingänge E1 bis E4 sondern über eine einzige Eingangsleitung in serieller Impulsfolge in den Zwischenspeicher des Mikrocomputers 11 oder eines Mikroprozessors einzugeben. Die Steuerbefehle werden dabei in Form von Taktimpulsen über eine zweite Eingangsleitung dem Eingang Eo oder einem anderen, dafür vorgesehenen Eingang der Eingangsports 17 bzw. 18 angelegt. Auch hier können die zu speichernden Kenndaten in mehreren Datenfolgen zyklisch nacheinander jeweils in den Zwischenspeicher des Mikrocomputers oder Mikroprozessors eingegeben werden und anschließend werden sie in den nichtflüchtigen Speicher 16 eingeschrieben. Das Einlesen der Daten einer solchen Datenfolge in den Zwischenspeicher erfolgt dabei jeweils durch Steuerbefehle auf der dafür vorgesehenen Eingangsleitung, die gemäß Figur 2 und Figur 4 bei dem beschriebenen Ausführungsbeispiel als Taktimpulse am Eingang Eo des Mikrocomputers 11 auftreten.

Besonders vorteilhaft bei der erfindungsgemäßen Lösung ist es, daß der Speicher mit den fahrzeugspezifischen Kenndaten ohne zusätzliche Hartware über die vorhandenen Eingangsleitungen programmierbar ist, die im normalen Betrieb des Fahrdatenrechners 10 oder eines anderen elektronischen Erzeugnisses im Kraftfahrzeug mit einem Mikrocomputer oder Mikroprozessor an verschiedene Sensoren, Überwachungsschaltern oder Tastschaltern zur Eingabe von Informationen angeschlossen sind. Eine solche Programmierung ist allgemein bei elektronischen Erzeugnissen mit einer Datenverarbeitung durch einen Prozessor und einen dafür erforderlichen programmierbaren nichtflüchtigen Speicher wesentlich günstiger als eine direkte Programmierung des nichtflüchtigen Speichers, weil dort die Programmierung über einen besonderen Datenbus mit nach außen geführter Steckverbindung zum Anschluß der Programmiereinrichtung erfolgt.

## Patentansprüche

1. Verfahren zur Speicherung von Informationen in einem programmierbaren, nichtflüchtigen Speicher (16) eines Rechners (10) zur Datenverarbeitung, der über einen Datenbus (15) und einen Adressbus (14) mit einem Mikroprozessor (11) fest verbunden ist, in dem über mehrere, an Eingängen des Mikroprozessors angeschlossene Eingangsleitungen (17 ; Eo, ..., E5) im normalen Betrieb des Rechners laufend veränderliche Daten und Befehle zur Verarbeitung eingelesen werden, wobei mit einem externen Schalter (24, 25, 27) über mindestens eine Eingangsleitung (Eo) ein bestimmter Steuerbefehl (1. Takt) eingegeben und damit ein Unterprogramm (UP1, 2) des Mikroprozessors aufgerufen wird, mit dem zusätzliche Daten von außen zunächst in einen Zwischenspeicher des Mikroprozessors eingelesen und anschließend aus dem Zwischenspeicher in den nichtflüchtigen Speicher (16) eingeschrieben werden, dadurch gekennzeichnet, daß als zusätzliche, von außen kommende Daten für den in einem Fahrzeug zu verwendenden Rechner (10) fahrzeugspezifische Informationen in Form einer Datenfolge über mindestens eine derjenigen weiteren Eingangsleitungen (E1 bis E4) eingelesen werden, die im normalen Betrieb des rechners (10) an die verschiedenen Signalgeber im Fahrzeug für die laufend veränderlichen Daten und Befehle angeschlossen werden.

2. Verfahren nach Anspruch 1, dadurch gekennzeichnet, daß mehrere Datenfolgen zyklisch nacheinander jeweils in den Zwischenspeicher des Mikroprozessors (11) eingelesen und anschließend von dort in den nichtflüchtigen Speicher (16) eingeschrieben werden.

3. Verfahren nach Anspruch 1 oder 2, dadurch gekennzeichnet, daß das Einlesen der Daten einer Datenfolge in den Zwischenspeicher des Mikroprozessors (11) durch weitere Steuerbefehle (4. 5. ... Takt) auf der dafür vorgesehenen Datenleitung (Eo) erfolgt.

4. Verfahren nach einem der vorherigen Ansprüche, dadurch gekennzeichnet, daß vor dem Eingeben einer Datenfolge auf der selben Eingangsleitung (E1 bis E4) zunächst eine Anfangsadresse für die nachfolgend im nichtflüchtigen Speicher (16) abzuspeichernden Daten durch einen Steuerbefehl (3. Takt) auf der entsprechenden Eingangsleitung (Eo) in den Zwischenspeicher des Mikroprozessors (11) eingegeben wird.

5. Verfahren nach Anspruch 4, dadurch gekennzeichnet, daß nach jeder in den nichtflüchtigen Speicher (16) eingeschriebenen Datenfolge eine neue Adresse für die nachfolgende Datenfolge in den Mikroprozessor (10) eingegeben wird.

6. Verfahren nach einem der vorherigen Ansprüche, dadurch gekennzeichnet, daß die Datenfolge durch mindestens einen externen Schalter (24) erzeugt werden, der mit den für die Programmierung verwendeten Eingangsleitungen (E1 bis E4) verbunden ist.

7. Verfahren nach Anspruch 6, dadurch gekennzeichnet, daß mit dem externen Schalter (24) über vier Eingangsleitungen (E1 bis E4) hexadezimalkodierte Adressen und Daten in den Mikroprozessor (11) eingegeben werden.

8. Verfahren nach Anspruch 1, dadurch gekennzeichnet, daß das Einlesen der Daten in den Zwischenspeicher des Mikroprozessors (11) durch ein externes Eingabegerät (26) mit einem Rechner erfolgt, der an die entsprechenden Eingangsleitungen (Eo bis E4) des Mikroprozessors (11) lösbar angeschlossen wird.

9. Verfahren nach Anspruch 8, dadurch gekennzeichnet, daß sämtliche im nichtflüchtigen Speicher (16) abzuspeichernde Daten in einer Datenfolge vom Rechner des Eingabegerätes (26) ausgegeben, in den Zwischenspeicher des Mikroprozessors (11) eingelesen, anschließend auf Vollständigkeit überprüft und schließlich in den nichtflüchtigen Speicher (16) eingeschrieben werden.

## Claims

1. Method for storing information in a programmable non-volatile memory (16) of a data processing computer (10) which is permanently connected via a data bus (15) and an address bus (14) to a microprocessor (11) into which continuously variable data and commands are read in for data processing in the normal operating mode of the computer via a plurality of input leads connected to inputs on the microprocessor, a particular control command being entered by means of an external switch (24, 25, 27) via at least one input lead (Eo) and thus calling up a subprogram (UP1, 2) of the microprocessor, which is used to read in additional data from outside initially into an intermediate memory of the microprocessor and then to write the data from the intermediate memory into the non-volatile memory (16), characterized in that, as additional data coming from the outside for the computer to be used in a vehicle, vehicle-specific information in the form of a data series are read in via at least one of the further input leads (E1 to E4), which in the normal operating mode of the computer (10) are connected to the various signal generators in the vehicle for the continuously variable data and commands.

2. Method according to Claim 1, characterized in that several data series can be read in cyclically one after the other into the intermediate memory of the microprocessor (11) and then from there written into the non-volatile memory (16).

3. Method according to Claim 1 or 2, characterized in that the reading in of the data of a data series into the intermediate memory of the microprocessor (11) occurs by means of further control commands (4th 5th ... clock) on the data lead (Eo) provided for that purpose.

4. Method according to one of the preceding claims, characterized in that, before a data series is input over the same input lead (E1 to E4), an initial address for the data to be subsequently stored in the non-volatile memory (16) is first entered over the corresponding input lead (Eo) into the intermediate memory of the microprocessor (11) by means of a control command (3rd clock).

5. Method according to Claim 4, characterized in fact that a new address for the following data series is entered in the microprocessor (10) after each data series which is written into the non-volatile memory (16).

6. Method according to one of the preceding claims, characterized in that the data series is produced by at least one external switch (24), which is connected to the input leads (E1 to E4) used for programming.

7. Method according to Claim 6, characterized in that hexadecimally encoded addresses and data are input into the microprocessor (11) via four input leads (E1 to E4) using the external switch (24).

8. Method according to Claim 1, characterized in that the reading in of the data into the intermediate memory of the microprocessor (11) occurs by means of an external input unit (26) with a computer, which is detachably connected to the corresponding input leads (Eo to E4) of the microprocessor (11).

9. Method according to Claim 8, characterized in that all the data to be stored in the non-volatile memory (16) are issued in a data series by the computer of the input unit (26), read into the intermediate memory of the microprocessor (11), subsequently checked for completeness and finally written into the non-volatile memory (16).

## Revendications

1. Procédé pour mettre en mémoire des informations dans une mémoire (16) programmable rémanente d'un ordinateur de traitement des données qui est relié en permanence, par l'intermédiaire d'un bus de données (15) et d'un bus d'adresses, à un microprocesseur (11) dans lequel des données et des ordres de traitement variables sont lus en continu en fonctionnement normal de l'ordinateur, par l'intermédiaire de plusieurs lignes d'entrée (17 ; 80 ..., 85) raccordées aux entrées du microprocesseur, un certain ordre de commande (moment 1) étant introduit par un interrupteur externe (24, 25, 27), par l'intermédiaire d'au moins une ligne d'entrée (Eo) et un sous-programme (UP, 1, 2) du microprocesseur étant ainsi appelé, avec les données supplémentaires venant de l'extérieur introduites en premier lieu dans une mémoire intermédiaire du microprocesseur et ensuite enregistrées, à partir de la mémoire intermédiaire, dans la mémoire rémanente (16), caractérisé en ce que les données supplémentaires venant de l'extérieur, destinées à un ordinateur (10) utilisable dans un véhicule, sont des informations spécifiques au véhicule, introduites sous la forme d'une suite de données, par l'intermédiaire d'au moins une des autres lignes d'entrées (E1 à E4), raccordées en fonctionnement normal de l'ordinateur (10) à différents capteurs de signaux situés dans le véhicule, pour les données et ordres variables en continu.

2. Procédé selon la revendication 1, charactérisé en ce que plusieurs suites de données sont chaque fois introduites cycliquement les unes après les autres dans la mémoire intermédiaire du microprocesseur (11) et ensuite enregistrée à partir de là dans la mémoire rémanente (16).

3. Procédé selon la revendication 1 ou 2, caractérisé en ce que l'introduction des données d'une suite de données dans la mémoire intermédiaire du microprocesseur (11) s'effectue par des ordres de commande supplémentaires (moment 4, 5 ...) sur la ligne de données (Eo) prévue à cet effet.

4. Procédé selon l'une des revendications précédentes, caractérisé en ce qu'avant introduction d'une suite de données sur la même ligne d'entrée (E1 à E4), on introduit d'abord dans la mémoire intermédiaire une adresse initiale pour les données à placer ensuite en mémoire dans la mémoire rémanente (16), au moyen d'un ordre de commande (moment 3) sur la ligne d'entrée correspondante (Eo).

5. Procédé selon la revendication 4, caractérisé en ce qu'une nouvelle adresse est introduite dans le microprocesseur (10) pour la suite de données suivante, après chaque suite de données enregistrées dans la mémoire rémanente (16).

6. Procédé selon l'une des revendications précédentes, caractérisé en ce que la suite de données est produite par au moins un interrupteur externe (24) qui est relié aux lignes d'entrée (E1 à E4) utilisées pour la programmation.

7. Procédé selon la revendication 6, caractérisé en ce que des adresses et des données codées de façon hexadécimale sont introduites dans le microprocesseur (11), par l'interrupteur externe (24), par l'intermédiaire de quatre lignes d'entrée (E1 à E4).

8. Procédé selon la revendication 1, caractérisé en ce que l'introduction des données dans la mémoire intermédiaire du microprocesseur (11) s'effectue au moyen d'un appareil d'entrée externe (26) avec un ordinateur raccordé de manière déconnectable aux lignes d'entrée (Eo à E4) du microprocesseur (11).

9. Procédé selon la revendication 8, caractérisé en ce que l'ensemble des données à placer en mémoire dans la mémoire rémanente (16) est délivrée sous forme de suite de données par l'ordinateur de l'appareil d'entrée (26), et est introduit dans la mémoire intermédiaire du microprocesseur (11), puis ensuite soumis à un contrôle de son intégralité, et finalement enregistré dans la mémoire rémanente (16).

## FIG. 1

## FIG. 2

| | 1 | 2 | 3 | 4 | 5 | 6 | 7 | 8 | | |
|---|---|---|---|---|---|---|---|---|---|---|
| E0 | | | | | | | | | | |
| E1 | | | | | | | | | | |
| E2 | | | | | | | | | | |
| E3 | | | | | | | | | | |
| E4 | | | | | | | | | | |

|  | A | 4 | 3 | A | 9 | 8 | 5 | |
|---|---|---|---|---|---|---|---|---|
| START | HAND PROGRAM. | ADR. | | DATEN | | | ADR. | DATEN |

# FIG. 3

JUMP UP 1 — 30

no → TAKT 1 — 31

HAND PROGR — 32 → no → UP 2 — 45

no → TAKT 0 — 33

no → TAKT 1 — 34

ADR. EIN. — 35

no → TAKT 0 — 36

ZAHLER 4 — 37

no → TAKT 1 — 38

DATEN EIN — 39
ZAHLER -1 — 40

no → TAKT 0 — 41

ZAHLER 0 — 42 → no

DATEN SPEICHERN — 43

# FIG. 5

JUMP UP 2 — 45

RECHNER PROGR — 46 → no → RET. — 47

ZAHLER SETZEN — 48

DATEN EIN — 49
ZAHLER -1 — 50

ZAHLER 0 — 51 → no

PRUFZAHL EIN — 52

SUMME I.O. — 53 → no → FEHLER-ANZEIGE — 54

DATEN SPEICHERN — 56

RET. — 57

RET — 55

# FIG. 4